# EUROPÄISCHE PATENTSCHRIFT

(11) **EP 3 344 812 B1**
(45) Veröffentlichungstag und Bekanntmachung des Hinweises auf die Patenterteilung: **20.01.2021**
(21) Anmeldenummer: 16753311.6
(22) Anmeldetag: 05.08.2016
(51) Int. Cl.: D06F 39/00, A47L 15/42, G06F 3/044, H03K 17/96

(54) **HAUSHALTSGERÄT MIT EINER VERBESSERTEN BEDIENBARKEIT EINER ALS TOUCHSCREEN AUSGESTALTETEN BEDIENEINRICHTUNG**
DOMESTIC APPLIANCE HAVING IMPROVED OPERABILITY OF AN OPERATING DEVICE DESIGNED AS A TOUCH SCREEN
APPAREIL MÉNAGER DONT LE DISPOSITIF DE MANIPULATION RÉALISÉ SOUS LA FORME D'UN ÉCRAN TACTILE PRÉSENTE UNE FACILITÉ D'UTILISATION AMÉLIORÉE

(30) Priorität: 31.08.2015 DE 102015216628
(43) Veröffentlichungstag der Anmeldung: 11.07.2018
(73) Patentinhaber: BSH Hausgeräte GmbH, 81739 München (DE)
(72) Erfinder: BREME, Jonas, 12049 Berlin (DE); GEYER, Johannes, 85540 Haar (DE); GORODEZKI, Swetlana, 10247 Berlin (DE); IVANIS, Christian, 12047 Berlin (DE); KADEL, Hans-Peter, 12435 Berlin (DE); KOCH, Bastian, 12045 Berlin (DE); MILDE, Manuel, 80805 München (DE)
(86) Internationale Anmeldenummer: PCT/EP2016/068823
(87) Internationale Veröffentlichungsnummer: WO 2017/036737

(56) Entgegenhaltungen:
- EP-A1- 2 392 859
- WO-A2-2012/118285
- US-A- 4 204 204
- US-A1- 2008 235 614
- US-A1- 2011 062 143
- US-A1- 2013 092 033
- US-A1- 2015 013 074

## Beschreibung

Die Erfindung betrifft ein Haushaltsgerät mit einer als externer oder interner Touchscreen ausgestalteten Bedieneinrichtung. Die Erfindung betrifft insbesondere ein Haushaltsgerät zur Behandlung von Gegenständen, aufweisend eine Steuereinrichtung und eine als externer oder interner Touchscreen ausgestaltete Bedieneinrichtung, wobei die Steuereinrichtung eingerichtet ist, um auf mindestens einem Teil des Touchscreens innerhalb einer Bildschirmanzeige ein Anzeigefeld darzustellen, in dem mindestens ein Bedienelement und mindestens ein Anzeigeelement zur Einstellung und Anzeige einer durch Berührung einstellbaren Steuergröße des Haushaltsgerätes angeordnet sind, Die Erfindung betrifft außerdem ein Verfahren zum Betrieb eines solchen Haushaltsgeräts.

Zur Bedienung von zahlreichen Geräten wie Computern und Smartphones ist es in den letzten Jahren zunehmend beliebter geworden, eine berührungsempfindliche Bedieneinrichtung zu verwenden. Eine solche berührungsempfindliche Bedieneinrichtung, die eine Anzeigevorrichtung mit einer Bedieneinheit kombiniert und im Folgenden auch als "Touchscreen" bezeichnet wird, ermöglicht prinzipiell eine angenehme und rasche Bedienung des betreffenden Gerätes.

Bekannt sind mittlerweile auch Haushaltsgeräte mit einem Touchscreen.

So beschreiben die DE 10 2011 081 331 A1 und die WO 2013/026734 A1 ein Haushaltsgerät mit einer berührungssensitiven Bedien- und Anzeigeeinrichtung, welche eine Anzeigeeinheit zur Anzeige von Bedieninformationen und ein transparentes Trägerteil aufweist, an welchem zumindest eine kapazitive Sensorelektrode als Teil eines Berührungskondensators angeordnet ist, welche in Überlappung mit der Anzeigeeinheit und in Überlappung mit einer berührungssensitiven Betätigungsfläche der Bedien- und Anzeigeeinrichtung angeordnet ist, wobei die zumindest eine Sensorelektrode aus einem transparenten und elektrisch leitfähigen Lack und/oder Kleber ausgebildet ist, welcher insbesondere Nanoröhrchen aus Kohlenstoff beinhaltet.

Die DE 10 2011 077 902 A1 beschreibt eine kapazitive Bedien- und Anzeigeeinrichtung für ein Haushaltsgerät, mit einem Anzeigefenster mit einer berührungsempfindlichen Bedienfläche, wobei am Anzeigefenster ein Anzeigesymbol angebracht ist, mit mindestens einem Leuchtelement zur Abgabe von Licht zum Hinterleuchten des Anzeigesymbols, und mit einer kapazitiven Sensorelektrode als Teil eines Berührungskondensators, welche in einem Abstand zur Bedienfläche angeordnet sind, so dass beim Berühren der Bedienfläche eine Kapazität des Berührungskondensators veränderbar ist, wobei die Sensorelektrode an einer Leiterplatte angeordnet ist und zwischen der Bedienfläche und der Sensorelektrode ein Element angeordnet ist, welches aus einem elastischen, elektrisch isolierenden Material ausgebildet ist.

Die DE 10 2012 223 779 A1 beschreibt ein Haushaltsgerät mit einer Steuereinrichtung, einer mindestens teilweise lichtdurchlässigen Blende sowie mit einem mindestens teilweise lichtdurchlässigen Bedienpanel mit mindestens einem kapazitiven Sensor zur Auswahl einer Programmfunktion des Haushaltsgerätes durch einen Benutzer des Gerätes, wobei das Bedienpanel ein aus mehreren Schichten bestehendes Kunststoffbauteil aufweist, umfassend (a) eine Anzeigedisplayfolie; (b) eine berührungsempfindliche Folie, welche den mindestens einen kapazitiven Sensor sowie elektrische Leiterbahnen aufweist; und (c) eine strukturierte Lichtleiterschicht; wobei das Kunststoffbauteil erhältlich ist durch Verbinden einer selbstklebenden Anzeigedisplayfolie mit der berührungsempfindlichen Folie und ein anschließendes Hinterspritzen der strukturierten Lichtleiterschicht.

Die WO 2012/175523 A1 beschreibt eine Bedien- und Anzeigeeinrichtung für ein Haushaltsgerät, wobei kapazitive Sensorelektroden in Überlappung mit der berührungsempfindlichen Betätigungsfläche angeordnet sind und zumindest einem Teil von Funktionszeichen, denen ein Wert eines Parameters eines Betriebsprozesses des Haushaltsgerätes zugeordnet sind, jeweils eine separate kapazitive Sensorelektrode zugeordnet ist, welche in Überlappung mit dem ihr zugeordneten Funktionszeichen angeordnet ist, so dass durch Berührung der Betätigungsfläche in einem Überlappungsbereich mit einer der Sensorelektroden eine Kapazität eines diese Sensorelektrode aufweisenden Berührungskondensators veränderbar ist.

Die Steuerung eines Haushaltsgeräts über einen Touchscreen kann dann sehr schwierig sein, wenn die Anzahl von ausführbaren Programmen und Einstellmöglichkeiten von Parametern sehr groß ist. Dies gilt insbesondere bei Haushaltsgeräten zur Behandlung von Gegenständen wie Wäsche, Geschirr und Lebensmitteln. Bei einer komplexen Hierarchie von Programmen und Einstellmöglichkeiten kann ein Benutzer des Haushaltsgerätes leicht überfordert werden und den Überblick über die Steuerung verlieren. Dies ist vor allem der Fall, wenn es für bestimmte Programmschritte auch noch viele einzelne Einstellmöglichkeiten gibt. Es ist aber gerade die Möglichkeit der Eingabe von optimalen Einstellungen, welche einen sehr effizienten und komfortablen Betrieb eines Haushaltsgeräts gestatten kann. Neben einem im Hinblick auf den Verbrauch an Energie und Einsatzmaterialien wie Wasser, Reinigungsmittel, usw. wirtschaftlicheren Betrieb des Haushaltsgerätes kann der Betrieb zusätzlich besonders benutzerfreundlich gestaltet werden, wenn die Eingabe von optimalen Einstellungen möglich ist.

Die Größe des Touchscreens begrenzt jedoch den Bereich von Bewegungen, der zur Einstellung von Parametern benutzt werden kann, sowie die Anzahl der Parameter, die durch Verwendung eines Touchscreens eingestellt werden können. Dies erfordert häufig eine tiefe Hierarchie von Menüs und Fenstern zur Einstellung von Parametern, die für ein im Haushaltsgerät durchzuführendes Programm verwendet werden sollen. Damit verzögert sich jedoch die Steuerung eines Programms oder aber es werden von einem vielleicht nicht sehr geduldigen Benutzer nicht optimierte Verfahrensweisen vorgegeben, so dass der Betrieb des Haushaltsgerätes nicht optimal erfolgt. Eine verbesserte und auf die Ausnutzung des gesamten Programm- und Optionsportfolios ausgelegte, erleichterte Bedienung von Haushaltsgeräten ist daher wünschenswert.

Die US 2011/062143 A1 beschreibt ein Kochgerät mit einem berührungsempfindlichen Kontrolldisplay, das angepasst ist, um einen interaktiven Kochzeit-Verzögerungsbildschirm darzustellen, beinhaltend eine erste virtuelle Gleitleiste ("slide bar"), die angepasst ist, um durch einen Benutzer entlang einer ersten virtuellen Bahn positioniert zu werden, worin die erste virtuelle Bahn eine Zeitachse einrichtet, enthaltend Zeitangaben an voneinander beabstandeten Intervallen entlang der ersten virtuellen Bahn. Dabei hat die erste virtuelle Gleitleiste eine Länge, welche einer Gesamtzeit eines Kochzyklus mit einer Startzeit und einer Stoppzeit entspricht, so dass das Verschieben der ersten virtuellen Gleitleiste entlang der ersten virtuellen Bahn gleichzeitig die Startzeit und die Stoppzeit des Kochzyklus einstellt und es dem Benutzer erlaubt, das Kochen bis zu einer ausgewählten Startzeit zu verzögern; und einer Steuereinheit in Kommunikation mit der Benutzeroberfläche zur Regelung des Betriebs des Kochgerätes basierend auf der Positionierung der ersten virtuellen Gleitleiste entlang der ersten virtuellen Bahn. Das Kontrolldisplay ist außerdem angepasst, um einen Bildschirm für die Temperaturauswahl sowie einen Bildschirm für die Auswahl einer gewünschten Dauer des Kochzyklus einzustellen, wobei für die Einstellung jeweils eine Gleitleiste vorgesehen ist, wobei die Gleitleiste einzelne Segmente zu enthalten scheint.

Die US 2013/092033 A1 beschreibt einen Ofen, umfassend eine Kochkammer, die konfiguriert ist, um ein Lebensmittelprodukt aufzunehmen, eine Benutzeroberfläche, die konfiguriert ist, um Informationen betreffend Verfahren zum Kochen des Lebensmittelproduktes darzustellen; und ein Kochregelgerät, welches operativ mit der Benutzeroberfläche verbunden ist, um die Darstellung von Kochparameter-Eingabeseiten zu steuern, um es einem Benutzer zu ermöglichen, Kochparameter zu definieren und Kochparameter einzustellen, worin jede der gezeigten Eingabeseiten ein Auswahlindikator-Band enthält, das graphische Elemente anzeigt, die jedem der über vorhergehende Seiten eingegebenen Kochparameter entsprechen. In Fig. 16 ist eine Gleitleiste für die Einstellung einer Temperatur gezeigt, wobei neben der Anzeige des Wortes "Temperatur" sowie einer Fläche 640 zur Auswahl von Anwendungsoptionen über der Gleitleiste der Anfangswert und der Endwert der Temperatur angegeben sind. Außerdem wird ein offenbar einer ausgewählten Position auf der Gleitleiste entsprechender Temperaturwert vergrößert dargestellt. Ähnliche Gleitleisten sind für die Einstellung einer Konvektionskeit bzw. einer Gebläsegeschwindigkeit beschrieben.

Die US 4,204,204 beschreibt Ein-Aus-Schalteranordnungen für eine berührungsempfindliche, graphische Leistenvorrichtung ("touch control bar graph device"), die unter anderem umfasst: eine berührungsempfindliche "Ein"-Fläche, welche in Nachbarschaft zur berührungsempfindlichen, graphischen Leistenvorrichtung, aber von dieser räumlich getrennt, angeordnet ist; und eine abschaltende, berührungsempfindliche Fläche zwischen der "Ein"-Fläche und der berührungsempfindlichen, graphischen Leistenvorrichtung; wobei jeder Versuch durch einen Benutzer, den Betrieb dieser Leistenvorrichtung durch eine direkte Bewegung eines Fingers von der "Ein"-Fläche zur Leistenvorrichtung zu bewirken, zu einer Abschaltung der Leistenvorrichtung führt. Damit soll die Sicherheit bei der Bedienung erhöht werden.

Vor diesem Hintergrund war es Aufgabe der vorliegenden Erfindung, ein Haushaltsgerät zur Behandlung von Gegenständen mit einer verbesserten Bedienbarkeit bereitzustellen. Vorzugsweise soll dabei ebenfalls die Komplexität der Informationsausgabe an einen Benutzer reduziert und somit eine übersichtlichere und damit fehlerreduzierte Bedienung ermöglicht werden. Außerdem soll ein Verfahren zum Betrieb dieses Haushaltsgeräts bereitgestellt werden.

Die Lösung dieser Aufgabe wird nach dieser Erfindung erreicht durch ein Haushaltsgerät zur Behandlung von Gegenständen (im Folgenden auch mit "Haushaltsgerät" abgekürzt) sowie ein zu dessen Betrieb geeignetes Verfahren mit den Merkmalen der entsprechenden unabhängigen Patentansprüche. Bevorzugte Ausführungsformen des erfindungsgemäßen Haushaltsgeräts sowie des erfindungsgemäßen Verfahrens sind in den jeweiligen abhängigen Patentansprüchen aufgeführt. Bevorzugten Ausführungsformen des erfindungsgemäßen Haushaltsgeräts entsprechen bevorzugte Ausführungsformen des erfindungsgemäßen Verfahrens und umgekehrt, auch wenn dies hierin nicht explizit festgestellt ist.

Der Rahmen der Erfindung wird durch den Schutzumfang der Ansprüche definiert. Der Gegenstand jeglichen Bezugs auf "Ausführungsformen", "Beispiele" oder "Aspekte" der Erfindung in der Beschreibung, welcher nicht unter den Schutzumfang der Ansprüche fällt, sollte lediglich als Illustration oder Beispiel zum besseren Verständnis der Erfindung interpretiert werden.

Gegenstand der Erfindung ist somit ein Haushaltsgerät gemäß Anspruch 1.

Die Begriffe "Anzeigeelement" und "Bedienelement" sind breit auszulegen. Mittels beider Elemente kann im Allgemeinen eine Information für einen Benutzer bereitgestellt werden. Der Begriff "Anzeigeelement" bedeutet hierin aber insbesondere ein Element, das nur eine Anzeige von Informationen ermöglicht, aber keine Eingabe durch einen Benutzer. Im Gegensatz zu dem Begriff "Bedienelement", der für ein Element steht, das nicht nur die Anzeige von Informationen ermöglicht, sondern bei dem auch eine Eingabe durch einen Benutzer gemacht werden kann. Bedienelemente weisen hierzu insbesondere Berührungsschalter (hierin auch als "Sensorelemente" bezeichnet) auf. Erfindungsgemäß ist mindestens ein Bedienelement ein längliches, flächiges Sensorelement. Dies kann beispielsweise in der Form eines Balkens realisiert werden. Die Dimensionen und die Gestalt des Balkens sind dabei erfindungsgemäß nicht eingeschränkt. Es kann sich dabei beispielsweise um eine schmale, lange, kantige Ausgestaltung handeln, aber auch um eine breite, abgerundete, ebenso kann die Ausgestaltung aber auch eine unregelmäßige Form aufweisen. Das längliche, flächige Sensorelement weist vorzugsweise mindestens drei Segmente auf. Die Art der Darstellung der drei Segmente ist dabei erfindungsgemäß nicht eingeschränkt. Sie können für einen Benutzer optisch wahrnehmbar dargestellt sein oder auch optisch nicht wahrnehmbar. Eine optisch wahrnehmbare Darstellung kann dabei beispielsweise eine Unterteilung des länglichen, flächigen Sensorelements durch vertikale Linien und/oder Bereiche sein. Ebenso ist auch eine unterschiedliche Farbgebung denkbar, wobei Farbgebung erfindungsgemäß alle Farben, sowie schwarz, weiß und Graustufen umfasst, eine unterschiedliche Form und/oder ein unterschiedliches Design, wobei Design erfindungsgemäß graphische und haptische Muster umfasst.

Hinsichtlich des physikalischen Prinzips ist die Art des Berührungsschalters nicht eingeschränkt. Bevorzugt werden jedoch kapazitive Berührungsschalter bzw. Bedienelemente verwendet. Jedenfalls kann mittels eines solchen Bedienelementes eine Eingabe zur Einstellung einer Steuergröße des Haushaltsgeräts durch einen Benutzer gemacht werden.

Es können auch weitere Bedienelemente vorhanden sein, wobei die Ausgestaltung der weiteren Bedienelemente und/oder Anzeigeelemente ansonsten erfindungsgemäß nicht eingeschränkt ist. Die Ausgestaltung richtet sich im Allgemeinen nach den darzustellenden Informationen. Bedienelemente und/oder Anzeigeelemente können nämlich ansonsten jedwede Form besitzen. Ein Element kann beispielsweise rechteckig oder rund sein, aber auch komplexere Formen annehmen.

Im erfindungsgemäßen Haushaltsgerät besteht zwischen dem ersten Segment und den weiteren Segmenten im länglichen, flächigen Sensorelement ein größerer Abstand als zwischen den weiteren Segmenten. Da dem ersten Segment ein niedrigster Wert der einstellbaren Steuergröße oder eine OFF-Funktion zur Deaktivierung der einstellbaren Steuergröße zugeordnet ist, ist eine leichtere und schnellere Bedienung des Haushaltsgerätes möglich. Die Größe des Abstands sowie die relative Positionierung des ersten Segmentes bezüglich der weiteren Segmente sind dabei erfindungsgemäß nicht eingeschränkt. Bevorzugt ist das erste Segment jedoch in horizontaler Richtung den weiteren Segmenten vorgelagert dargestellt. Eine optisch nicht wahrnehmbare Darstellung der in der Regel mindestens drei Segmente ist erfindungsgemäß eine kontinuierliche Darstellung, welche beispielsweise als ein ununterbrochener Balken erscheint. Auch die Form der Segmente ist erfindungsgemäß nicht eingeschränkt. Sämtliche der z.B. drei Segmente können die gleiche Form aufweisen, die Formen können aber auch voneinander verschieden sein. So kann beispielsweise das erste Segment kreisrund ausgeführt sein und die weiteren Segmente rechteckig, es können aber auch alle Segmente rechteckig sein. Auch komplexe Formen der Segmente sind denkbar, wie etwa eine Sternform.

Der Begriff "Berührung" ist breit auszulegen, indem er jegliche Berührungen mit einer externen Eingabeeinheit umfasst, die in ein elektrisches Signal, auch als "Berührungssignal" bezeichenbar, umgewandelt werden können. Erfindungsgemäß kann eine externe Eingabeeinheit beispielsweise der Finger eines Benutzers sein und/oder auch ein Stift. Entsprechend kann eine Berührung ganz allgemein mit einer Eingabeeinheit vorgenommen werden. Die externe Eingabeeinheit dient dazu, Berührungssignale auf dem Touchscreen zu erzeugen, wobei Berührungssignale in der Regel Bewegungen wie z.B. Drücken, Ziehen, Wischen und/oder Drehen umfassen.

Der Begriff "einstellbare Steuergröße" ist breit auszulegen. Erfindungsgemäß umfassen einstellbare Steuergrößen eines Haushaltsgeräts Behandlungsprogramme, Programmparameter und/oder Zusatzoptionen, welche zum Betrieb eines Haushaltsgeräts vorgesehen sind, solange dem ersten Segment ein niedrigster Wert der einstellbaren Steuergröße oder eine OFF-Funktion zur Deaktivierung der Steuergröße zugeordnet sein kann und den mindestens zwei weiteren Segmenten jeweils unterschiedliche Werte der einstellbaren Steuergröße zugeordnet sein können. Je nach Art und technischer Ausstattung des Haushaltsgeräts kann die Anzahl an solchen Steuergrößen variieren. Eine einstellbare Steuergröße umfasst erfindungsgemäß im Allgemeinen mindestens drei Werte. So kann ein Behandlungsprogramm beispielsweise mehrere Programmparameter umfassen, wie etwa in einem Haushaltsgerät, welches als Waschmaschine ausgeführt ist, die Programmparameter Temperatur, Schleudern und Zeit. Ein Programmparameter, wie beispielsweise die Temperatur kann ebenso mehrere Werte umfassen, etwa kalt, 30°C, 40°C, 60°C und 90°C. Jedenfalls weist eine einstellbare Steuergröße in einem Haushaltsgerät vorzugsweise mindestens drei zur Einstellung auswählbare Werte auf.

Erfindungsgemäß ist die Art und Weise der Einstellung der einstellbaren Steuergrößen nicht weiter eingeschränkt. Es kann sich dabei um die Auswahl von Programmparametern eines Behandlungsprogramms handeln oder um die Modifizierung von vorab in der Steuereinrichtung hinterlegten Default-Werten, welche in der Regel für Standardprogramme hinterlegt sind. Es kann sich aber auch um eine benutzerdefinierte Einstellung handeln oder um die Einstellung von Zusatzoptionen. Eine Zusatzoption kann dabei beispielsweise ein zusätzlicher Spülvorgang in einer Waschmaschine sein oder ein verzögerter Start eines Programmablaufs oder auch ein auf die Erfüllung sonstiger Vorgaben wie Schnelligkeit ausgelegter Programmablauf in einer Waschmaschine, z.B. ein möglichst rasch ablaufendes Waschprogramm, oder ein auf Energieeffizienz ausgelegtes Waschprogramm, ein Hygieneschritt oder beispielsweise auch ein an eine individuelle Verschmutzung angepasstes Waschprogramm, wie etwa bei Blaubeer- oder Rotweinflecken.

Erfindungsgemäß können einstellbare Steuergrößen von einem Benutzer durch Berührung der Bedienelemente eingestellt werden. Erfindungsgemäß ist mindestens ein Bedienelement ein längliches, flächiges Sensorelement, welches mindestens drei Segmente aufweist. Weist die einstellbare Steuergröße insbesondere eine Werteskala von mindestens drei Werten auf, ist ein solches Bedienelement von Vorteil. Wird eine einstellbare Steuergröße mittels Berührung eines länglichen, flächigen Sensorelements eingestellt, so ist vorzugsweise jedem der Segmente des Sensorelements durch die Steuereinheit ein Wert auf der Werteskala oder eine Funktion zugeordnet, wobei dem ersten Sensorelement dabei vorzugsweise der niedrigste Wert und/oder die OFF-Funktion der einstellbaren Steuergröße zugeordnet sind. "OFF-Funktion" bedeutet hierin das Ausschalten der einstellbaren Steuergröße. Abhängig von der Art der Berührung kann sich der Wert der einstellbaren Steuergröße kontinuierlich oder sprunghaft ändern. Hierbei sind prinzipiell zwei Möglichkeiten für die Benutzung vorhanden. So kann bei einer ersten Möglichkeit ein im Wesentlichen örtlich festes Berühren mit einer externen Eingabeeinheit, insbesondere mit einem Finger, also gerade keine ziehende oder seitlich ablaufende Bewegung, als punktartige Berührung von der Steuereinheit ausgewertet werden. Dem Ort der punktartigen Betätigung ist dann im Allgemeinen ein bestimmter Wert zugeordnet, welcher dadurch eingestellt wird. Bei der zweiten Möglichkeit ist vorgesehen, dass zur Betätigung eine externe Eingabeeinheit, insbesondere ein Finger aufgelegt wird und vor allem in einer ziehenden Bewegung entlang des länglichen Sensorelementes bewegt wird. Diese Betätigung geht also über eine punktartige Berührung hinaus. In Abhängigkeit von der Länge und/oder dem Anfangspunkt und Endpunkt der Betätigung bzw. der ziehenden länglichen Bewegung wird ein entsprechender Wert eingestellt.

In einer Ausführungsform des erfindungsgemäßen Haushaltsgeräts ist es überdies bevorzugt, dass in der Steuereinrichtung Abhängigkeiten zwischen einstellbaren Steuergrößen hinterlegt sind, welche eine unvorteilhafte oder gar zu einem Schaden führende Eingabe an Kombinationen oder sonstige Eingaben durch einen Benutzer verhindern. Die Eingabe ist dabei bevorzugt durch die Steuereinrichtung blockiert. So kann beispielsweise für den Fall, dass das Haushaltsgerät ein Gargerät ist und durch einen Benutzer das Garen der Speise Kartoffel ausgewählt ist, die Eingabe einer Laufzeit von 3h blockiert sein.

Erfindungsgemäß ist die Darstellung von mindestens zwei Anzeigeelementen innerhalb eines Anzeigefeldes möglich. Anzeigeelemente dienen zur Bereitstellung von Informationen an einen Benutzer. Die Art der Darstellung und der Inhalt der Information sind dabei erfindungsgemäß nicht eingeschränkt. Jedenfalls dient die Darstellung der Anzeigeelemente der Unterstützung der Einstellung der Steuergröße mittels der Bedienelemente. Die Anzeigeelemente stellen dabei insbesondere bevorzugt einen niedrigsten und einen höchsten Wert sowie einen aktuell eingestellten Wert der Werteskala einer einstellbaren Steuergröße dar. Auf diese Weise erhält ein Benutzer eine Orientierung darüber, welcher Bereich an Werten zur Einstellung einer Steuergröße verfügbar ist. Dies ist insbesondere von Bedeutung, falls die Einstellung bestimmter Werte aufgrund einer unvorteilhaften und/oder zu Schaden führenden Kombination, welche in der Steuereinrichtung hinterlegt ist, blockiert ist.

In der Regel ist die zeitabhängige Darstellung von Anzeigeelementen erfindungsgemäß nicht eingeschränkt. Anzeigeelemente können entweder permanent auf dem Anzeigefeld dargestellt sein oder beispielsweise mit einer Zeitverzögerung. Die Darstellung von Anzeigeelementen kann aber auch durch ein Berührungssignal ausgelöst werden. Erfindungsgemäß ist es dabei insbesondere bevorzugt, wenn Anzeigeelemente zur Darstellung des niedrigsten und obersten Werts der Werteskala einer einstellbaren Steuergröße gleichzeitig oder unmittelbar nachfolgend einem ersten Berührungssignal auf einem Bedienelement dargestellt werden. Auf diese Weise kann die Komplexität einer Darstellung von Elementen auf einem Anzeigefeld reduziert werden und nur die für einen Benutzer zu einem Bedienzeitpunkt wichtigen Informationen werden dargestellt.

Überdies können in einem Anzeigefeld mehr als ein Bedienelement angeordnet sein, so dass über ein Anzeigefeld mehrere Steuergrößen eingestellt werden können. Schließlich können die Bedienelemente auch in mehreren Anzeigefeldern einer Bildschirmansicht angeordnet sein.

Die Darstellung von einstellbaren Steuergrößen auf dem Touchscreen wird erfindungsgemäß im Allgemeinen realisiert durch eine Darstellung von Bedienelementen und/oder Anzeigeelementen in Form von Text, umfassend Buchstaben, Zahlen und Sonderzeichen, und/oder Bild. Vorteilhaft ist auch eine Darstellung in Form einer Animation. Der Begriff "Animation" ist hierin weit gefasst und nicht näher eingeschränkt. Er umfasst erfindungsgemäß alle Arten dynamischer Darstellungen, beispielsweise einfache Blinksequenzen, sich bewegende Muster, Bilder und/oder Texte, aber beispielsweise auch Videosequenzen.

Die Art der Bilder und Animationen zur Darstellung von einstellbaren Steuergrößen ist erfindungsgemäß nicht eingeschränkt. Es kann sich beispielsweise um abstrakte und/oder realistische Darstellungen handeln, welche kontextbezogen sein können, also beispielsweise auf einen bestimmten Programmparameter. Sie können aber auch kontextfern sein, also beispielsweise lediglich zu einer Differenzierung dienen. Möglich ist auch eine benutzerspezifische Darstellung und/oder Farbwahl. In einer Ausführungsform des erfindungsgemäßen Haushaltsgeräts sind dazu in der Steuereinrichtung Darstellungspakete mit unterschiedlichen Layouts für den Touchscreen hinterlegt, welche von einem Benutzer je nach Vorliebe gewählt werden können.

In Ausführungsformen des erfindungsgemäßen Haushaltsgeräts kann z.B. für den Fall einer Waschmaschine die Einstellung des Programmparameters Temperatur zum Waschen von Baumwollwäschestücken sowohl durch die Begriffe Baumwolle und Temperatur als auch durch ein Bild einer Baumwollpflanze in Verbindung mit einem Bild eines Thermometers für einen Benutzer auf dem Touchscreen dargestellt werden. Aber auch die Darstellung einer Kombination aus Bild und Text ist möglich. Möglich ist auch eine animierte Bilddarstellung.

In einer weiteren bevorzugten Ausführungsform des erfindungsgemäßen Haushaltsgeräts können auch ein Einschaltvorgang, ein Abschaltvorgang und/oder ein Stand-By-Modus des Haushaltsgeräts in Form von Text, Bild und/oder Animation an einen Benutzer über den Touchscreen ausgegeben werden. So kann z.B. die Wendung "Guten Tag" beim Einschaltvorgang erscheinen, die Wendung "Auf Wiedersehen" beim Abschaltvorgang und/oder die Wendung "Pause" im Stand-By Modus. Die Anzeige kann z.B. aber auch in einer Bilddarstellung ausgeführt sein. So kann das Firmenlogo beim Einschaltvorgang erscheinen und/oder beim Abschaltvorgang verschwinden. Es ist auch möglich, dass Videosequenzen gezeigt werden, welche einem Benutzer z.B. eine Begrüßung, eine Verabschiedung und/oder eine Stand-By Situation vermitteln.

Im Allgemeinen weisen Bedienelemente und Anzeigeelemente abhängig von einem Bedienzeitpunkt für einen Benutzer eine unterschiedliche Geltung auf. "Geltung" bedeutet hierin den Grad der Wichtigkeit der Information. So besitzt beispielsweise bei einem Haushaltsgerät, welches als Waschmaschine ausgeführt ist, bei einer Einstellung einer Temperatur das Anzeigeelement Temperatur eine hohe Geltung G1, wohingegen das Anzeigeelement Schleudern eine geringere Geltung G2 besitzt. Erfindungsgemäß ist es daher bevorzugt, Elemente mit einer hohen Geltung G1 für einen Benutzer hervorgehoben darzustellen und Elemente mit einer niedrigeren Geltung G2 für einen Benutzer zurückgesetzt darzustellen und/oder auszublenden.

Die Art der Darstellung ist dabei erfindungsgemäß nicht eingeschränkt. Sie kann in schwarz-weiß erfolgen, in Graustufen und/oder farbig. Insbesondere kann die Darstellung dabei bevorzugt auch eine Farblogik besitzen. So können beispielsweise Bedien- und/oder Anzeigeelemente mit einer hohen Geltung G1 kontrastreich und/oder mit einer ersten Farbe hervorgehoben dargestellt werden und Bedien- und/oder Anzeigeelemente mit einer niedrigeren Geltung G2 kontrastarm und/oder mit einer zweiten Farbe zurückgesetzt dargestellt werden. Zudem ist auch eine Veränderung der Form eines Bedien- und/oder Anzeigeelementes in Abhängigkeit von der Geltung für einen Benutzer möglich, wobei vorzugsweise Elemente mit einer niedrigeren Geltung G2 mit einer geringeren Breite und/oder Höhe dargestellt sind. Auf diese Weise wird eine verbesserte Übersicht bereitgestellt und es ist einem Benutzer leicht möglich, wichtige Informationen zu einem bestimmten Bedienzeitpunkt visuell zu erfassen.

Ein solches Darstellungspaket für den Touchscreen umfasst beispielsweise Farben, Schwarz, Weiß und Blau, sowie unterschiedliche Graustufen. Der Touchscreen-Hintergrund für eine Übersichtsdarstellung kann beispielsweise schwarz sein und für eine Fläche, in welcher eine Einstellung stattfindet, beispielsweise eine Temperatureinstellung, weiß. Texte können, abhängig von der Geltung des darstellenden Bedien- und/oder Anzeigeelements, in Weiß und/oder Schwarz hervorgehoben für G1 und/oder in Grau zurückgesetzt für G2 dargestellt sein. So können z.B. bereits ausgewählte Programmparameter in Weiß und/oder Schwarz dargestellt sein und nicht ausgewählte und/oder nicht auswählbare in Grau. Bilddarstellungen und Animationen können ebenfalls in Blau und/oder in Weiß dargestellt sein. So kann z.B., für ein Haushaltsgerät zur Behandlung von Wäschestücken unterstützend zum Text Laufzeit, ein Bild einer Uhr in Blau gezeigt werden.

In einer weiteren bevorzugten Ausführungsform ist die Steuereinrichtung jedenfalls dazu eingerichtet, dass die Auswahl und Einstellung von einstellbaren Steuergrößen durch akustische und/oder optische Signale angezeigt wird.

So weist ein erfindungsgemäß bevorzugtes Haushaltsgerät einen Soundgenerator und einen Lautsprecher zur Erzeugung und Wiedergabe von im Zusammenhang mit der Einstellung der einstellbaren Steuergrößen stehenden akustischen Signalen auf. Überdies kann auf einem Touchscreen durch einen Klang in Kombination mit einer Berührung ein akustischer Eindruck, z.B. das Drücken einer Taste, vermittelt werden.

Die Art, die Ausgestaltung des Lautsprechers sowie dessen Anbringungsort sind dabei erfindungsgemäß nicht eingeschränkt. Er kann für einen Benutzer sichtbar angebracht oder aber für einen Benutzer unsichtbar in das Haushaltsgerät integriert sein. In der Steuereinrichtung des Haushaltsgeräts sind zudem mindestens ein Klang und/oder Klangsequenzen hinterlegt, welche einem Berührungssignal, einem Ein-/Ausschaltvorgang oder einem Wechsel zwischen zwei Bildschirmdarstellungen zugeordnet sind. So kann z.B. bei einer durch einen Benutzer erfolgten Berührung eines Bedienelementes gleichzeitig ein Klang durch die Steuereinrichtung ausgegeben werden, welcher den Eindruck des Drückens einer Taste vermittelt. Insbesondere ist es in einer weiteren Ausführungsform des erfindungsgemäßen Haushaltsgeräts bevorzugt, dass in der Steuereinrichtung zudem Klangsequenzen einem Berührungssignal, einem Ein-/Ausschaltvorgang oder einem Wechsel zwischen zwei Bildschirmdarstellungen zugeordnet sind. So können beispielsweise ein Einschaltvorgang und/oder ein Ausschaltvorgang einem Benutzer durch einen zugeordneten Klang und/oder eine Klangsequenz akustisch vermittelt werden.

In bevorzugten Ausführungsformen der Erfindung ist der Touchscreen eingerichtet, um bei Berührung einen haptischen Effekt zu vermitteln. Dies kann beispielsweise durch Vibration in Kombination mit einem Berührungssignal und/oder einer geeigneten Oberflächenmodifikation erreicht werden, z.B. über Vertiefungen wie Rillen oder runde Vertiefungen, welche an die Größe eines Fingers angepasst sind, kann ein haptischer Eindruck vermittelt werden. Art und Intensität des haptischen Effektes können dabei in Abhängigkeit von einem einer Eingabefläche zugeordneten Programmparameter und Parameterwert abhängen. Da außerdem in Ausführungsformen der Erfindung weitere Eingabeflächen vorgesehen sein können, z.B. ein Ein-Aus-Schalter, können auch diesen spezielle haptische Eigenschaften zugeordnet sein.

In einer bevorzugten Ausführungsform des erfindungsgemäßen Haushaltsgeräts kann die Bedieneinrichtung des Haushaltsgeräts daher zusätzlich eingerichtet sein, Vibrationen zu erzeugen. In der Steuereinrichtung sind dann beispielsweise ein Vibrationssignal oder Vibrationsabfolgen hinterlegt, welche bestimmten Berührungen zugeordnet sind. So kann z.B. bei einem Berührungssignal in Form eines Berührens oder Drückens auf den Touchscreen die Steuereinrichtung eine Vibration initiieren, die einem Benutzer den Eindruck eines Tastendrucks vermittelt.

In einer bevorzugten Ausführungsform des Haushaltsgeräts sind auch Kombinationen aus einer optischen, akustischen und haptischen Darstellung von Programmparametern und Parameterwerten durch den Touchscreen möglich.

Im Allgemeinen ist die Anzahl an einstellbaren Steuergrößen insbesondere in einem wasserführenden Haushaltsgerät groß. In der Regel begrenzt eine als Touchscreen ausgelegte Bedieneinrichtung den Bereich, in welchem Behandlungsprogramme und Parameterwerte übersichtlich dargestellt werden können.

Erfindungsgemäß sind Bedienelemente und/oder Anzeigeelemente mindestens innerhalb eines Anzeigefeldes dargestellt. Das Anzeigefeld nimmt dabei vorzugsweise einen Teil des Touchscreens ein. Es kann sich aber auch über die gesamte Fläche des Touchscreens erstrecken. Der Anteil der Touchscreenfläche, sowie die Ausgestaltung und die Form des Anzeigefeldes sind dabei erfindungsgemäß nicht eingeschränkt. In der Regel wird der Anteil der Touchscreenfläche, den das Anzeigefeld einnimmt, größer sein, wenn eine größere Anzahl an Informationen bereitgestellt werden muss. Ebenso wird der Anteil der Touchscreenfläche, den das Anzeigefeld einnimmt, größer sein, wenn das Anzeigefeld eine höhere Hierarchie aufweist. "Hierarchie" im Sinne der Erfindung bedeutet dabei insbesondere die Reihenfolge der Anordnung von Anzeigefeldern und Bildschirmanzeigen. Beispielsweise besitzt die beim Start eines Haushaltsgeräts zunächst dargestellte erste Bildschirmanzeige eine hohe Hierarchie. Zweite und folgende Bildschirmanzeigen, welche aus der ersten heraus dargestellt, also geöffnet werden können, besitzen eine niedere Hierarchie. Eine Bildschirmanzeige umfasst in der Regel eine oder mehrere Anzeigefelder.

Bildschirmanzeigen und insbesondere auch Anzeigefelder können einander unmittelbar folgen, d.h. ohne dass eine weitere Bildschirmanzeige oder ein weiteres Anzeigefeld zwischengeschaltet ist, oder mittelbar, d.h. mit einer oder mehreren zwischengeschalten Bildschirmanzeigen oder Anzeigefeldern. Es können mehrere Anzeigefelder gleichzeitig auf einem Touchscreen dargestellt sein. Die Ausgestaltung der Anzeigefelder ist dabei erfindungsgemäß nicht eingeschränkt. Sie richtet sich im Allgemeinen ebenfalls nach den darzustellenden Informationen. So wird beispielsweise eine Darstellung von Standardprogrammen in der Regel in Form einer Liste mit gleichmäßig verteilten Flächenabschnitten dargestellt sein. Bei der näheren Bestimmung eines durch einen Benutzer ausgewählten Behandlungsprogrammes bzw. Programmparameters, wie etwa die Einstellung einer Temperatur, wird die Flächenaufteilung vorzugsweise zugunsten dieser Anzeigefelder gewichtet sein. D.h., der diesem Anzeigefeld zugeordneten Fläche, in welcher z.B. die Temperatur und deren Einstellmöglichkeiten dargestellt sind, wird im Allgemeinen prozentual der größte Anteil zukommen, um eine größtmögliche Übersichtlichkeit und leichte Bedienung für einen Benutzer zu ermöglichen. Entsprechend sind gleichzeitig andere Anzeigefelder, welche nicht durch einen Benutzer zu einer Einstellung berührt werden, in einem kleineren Flächenanteil dargestellt und/oder ausgeblendet.

Im Allgemeinen kann ein Wechsel von einer Bildschirmanzeige oder einem Anzeigefeld zu einer zweiten Bildschirmanzeige oder einem zweiten Anzeigefeld und/oder ein Navigieren innerhalb einer Bildschirmanzeige oder einem Anzeigefeld kontinuierlich und/oder sprunghaft erfolgen. In einer Ausführungsform der Erfindung ist es dabei bevorzugt, dass die Steuereinrichtung des Haushaltsgeräts eingerichtet ist, einen solchen Wechsel durch Berührung eines dafür vorgesehenen Teils eines Bedienelements zu ermöglichen.

Im Allgemeinen kann ein Wechsel von einem Anzeigefeld zu einem zweiten Anzeigefeld und/oder ein Navigieren innerhalb eines Anzeigefeldes kontinuierlich und/oder sprunghaft erfolgen.

Die Steuereinrichtung ist vorzugsweise ebenfalls ausgestaltet, den unmittelbaren Start eines Behandlungsprogrammes zu ermöglichen, indem ein hierfür vorgesehener Teilbereich eines Bedienelementes berührt wird

Es ist überdies ein Haushaltsgerät bevorzugt, bei dem die Steuereinrichtung eingerichtet ist, zusätzlich den Wechsel zwischen einer Bildschirmanzeige B1 und einer Bildschirmanzeige B2 zu ermöglichen, indem ein hierfür vorgesehener Teilbereich eines Bedienelementes berührt wird.

Im Allgemeinen kann ein Benutzer durch Berührungen auf dem Touchscreen einstellbare Steuergrößen auswählen und/oder benutzerdefiniert einstellen. In einer bevorzugten Ausführungsform des erfindungsgemäßen Haushaltsgeräts weist die Steuereinrichtung daher einen Datenspeicher auf, in welchem benutzerdefinierte Einstellungen gespeichert und zur erneuten Durchführung im Haushaltsgerät auch wieder abgerufen werden können. Ein Benutzer kann hierzu beispielsweise nach erfolgter Einstellung ein Bedienelement mit einem Bild in Form eines Sterns und/oder eines Speichermediums berühren, welche die Funktion "Unter Favoriten Speichern" darstellt. Die Darstellung kann auch animiert sein.

Der Touchscreen kann auf unterschiedliche Weise realisiert werden, solange eine Berührung geeignet in elektrische Signale umgesetzt werden kann. Insbesondere sind Art und Aufbau des Touchscreens erfindungsgemäß nicht eingeschränkt. Es kann jeder Touchscreen verwendet werden, der geeignet ist, Informationen in Form von Text, Bild und/oder Animation wiederzugeben und Berührungen in auswertbare Signale umzuwandeln.

Vorzugsweise umfasst der Touchscreen eine Display-Anzeige mit einer Abdeckscheibe, sowie eine zwischen der Display-Anzeige und der Abdeckscheibe angeordnete Touchfolie. Erfindungsgemäß ist der Touchscreen zudem in mindestens zwei Richtungen berührungsempfindlich. Ein Bedienelement kann dabei insgesamt berührungsempfindlich ausgestaltet sein oder nur in Teilbereichen. Außerdem kann ein Bedienelement in mehrere unabhängig berührungsempfindliche Unterflächen unterteilt sein. Dadurch ist es beispielsweise möglich, durch Berühren eines ersten Bedienelementes, das einem Behandlungsprogramm zugeordnet ist, das Behandlungsprogramm unmittelbar zu starten, wenn eine erste Unterfläche berührt wird, oder aber das Behandlungsprogramm in Hinblick auf Programmparameter zu modifizieren, wenn eine zweite Unterfläche berührt und dadurch ein weitere Anzeigefeld dargestellt wird.

Die Art der Display-Anzeige auf dem Touchscreen des Haushaltsgerätes ist erfindungsgemäß nicht eingeschränkt. Beispielsweise kann ein LCD-, LED-, OLED- oder AMOLED-Display-Anzeige verwendet werden. Auf diese Weise können Bedienelemente oder Teilbereiche davon durch ein gezieltes Hinterleuchten und/oder eine andere Farbigkeit optisch hervorgehoben und/oder zurückgesetzt dargestellt werden, wobei "optisch hervorgehoben" einen besonders hohen Kontrast zum Displayhintergrund bedeutet und "optisch zurückgesetzt" einen besonders niedrigen Kontrast zum Displayhintergrund bedeutet.

Material und Ausgestaltung einer optional verwendeten Abdeckscheibe sind erfindungsgemäß ebenfalls nicht eingeschränkt. In einer bevorzugten Ausführungsform des erfindungsgemäßen Haushaltsgeräts wird jedoch eine Abdeckscheibe aus Plexiglas verwendet. Kunststoffe wie Plexiglas haben dabei insbesondere den Vorteil, im Vergleich beispielsweise zu Glas leichter verformbar zu sein, so dass auch Touchscreens mit einer von einer flachen Form abweichenden Form vergleichsweise einfach hergestellt werden können, beispielsweise konkav oder konvex gekrümmt. Vorzugsweise ist die Plexiglas-Abdeckscheibe dabei farblich getönt ausgestaltet, besonders bevorzugt ist sie schwarzgetönt. Auf diese Weise kann die Transparenz der Scheibe angepasst werden, so dass darunterliegende Komponenten des Touchscreens, die nicht sichtbar sein sollen, für einen Benutzer nicht sichtbar sind. In Ausführungsformen des erfindungsgemäßen Haushaltsgeräts kann die Abdeckscheibe zudem in Höhe und/oder Breite die Dimensionen des Touchscreens übertreffen. Auf diese Weise kann eine Plexiglas-Bedienblende mit integriertem Touchscreen realisiert werden.

Die Touchfolie ist erfindungsgemäß ebenfalls nicht eingeschränkt, solange sie Berührungen einer externen Eingabeeinheit in Signale umwandeln kann, die von der Steuereinrichtung zur Steuerung des Haushaltsgeräts verarbeitet werden können.

Es ist allerdings bevorzugt, dass als Bedienelemente Berührungsschalter auf kapazitiver Basis verwendet werden, die kapazitive Sensorelemente aufweisen. Insbesondere ist das längliche, flächige Sensorelement vorzugsweise ein kapazitives Sensorelement.

In einer bevorzugten Ausführungsform des erfindungsgemäßen Haushaltsgeräts ist die Touchfolie daher eine kapazitive Touchfolie. Die kapazitive Touchfolie umfasst dabei vorzugsweise mindestens eine Sensorelektrode, welche durch Annäherung und/oder Berührung durch eine externe Eingabeeinheit ein durch Änderungen der elektrischen Kapazität hervorgerufenes elektrisches Signal erzeugen kann. Besonders bevorzugt weist die Touchfolie ein Koordinatennetz aus Sensorelektroden auf. Zwischen den Sensorelektroden befindet sich dabei in der Regel ein isolierendes Material, ein sogenanntes Dielektrikum. Die Kapazität an den Kreuzungspunkten der Sensorelektroden wird dabei im Allgemeinen durch einen Schaltkreis erfasst. Erfindungsgemäß kann das Koordinatennetz aus Elektroden durch das Auftragen eines strukturierten, elektrisch leitfähigen Materials ausgebildet werden. Die Strukturierung kann vielfältige Formen von einfachen geometrischen Formen, wie Kreisen, Rechtecken, usw., bis hin zu komplizierten unregelmäßigen Formen aufweisen, aber auch Linien in X- und Y-Richtung sind möglich. Das elektrisch leitfähige Material ist vorzugsweise transparent, beispielsweise Indium-Zinnoxid (ITO). Besonders bevorzugt können aber auch transparente und leitfähige Lacke und/oder Kleber verwendet werden. Letztere haben insbesondere den Vorteil einer einfacheren Aufbringung auf geformte Oberflächen, beispielsweise konvexe oder konkave Oberflächen, ohne Einbußen in der Funktionalität. Zudem sind leitfähige Lacke und/oder Kleber häufig auch kostengünstiger.

Elektrisch leitfähige Schichten, wie Sensorelektroden oder Schaltkreise, werden im Allgemeinen durch Sputtern oder Siebdruck erzeugt.

Die Touchfolie ist in der Regel mit einer Auswerteelektronik verbunden, welche notwendig ist, um ein durch Änderungen der elektrischen Kapazität hervorgerufenes elektrisches Signal in Folge einer Annäherung und/oder Berührung von Sensorelektroden durch eine externe Eingabeeinheit zu erfassen. Der Begriff "Auswerteelektronik" umfasst dabei in der Regel elektronische Bauteile, Leiterbahnstrukturen, Lötverbindungen und ggf. weitere Komponenten. Die Auswerteelektronik ist im Allgemeinen mit der Steuereinrichtung des Haushaltsgeräts verbunden.

Die Touchfolie ist erfindungsgemäß bevorzugt flexibel ausgestaltet und kann zudem transparent sein und ist vorzugsweise aus einem Kunststoff gefertigt. Sie kann ein- oder mehrlagig ausgestaltet und auf die Abdeckscheibe geklebt oder direkt mittels Spritzgieß- oder Spritzprägeprozessen hinterspritzt werden. In einer Ausführungsform des erfindungsgemäßen Haushaltsgeräts ist die mindestens eine Sensorelektrode bzw. das Koordinatennetz aus Sensorelektroden an der Folie angeordnet, dabei kann die mindestens eine Sensorelektrode bzw. das Koordinatennetz aus Sensorelektroden entweder auf der der Abdeckscheibe zugewandten oder abgewandten Seite angeordnet sein.

Die Anordnung des Touchscreens am Haushaltsgerät ist nicht besonders eingeschränkt. Vorzugsweise ist jedoch der Touchscreen in einem Winkel von 10° bis 45°, bezogen auf eine vertikale Achse auf einer Grundfläche des Haushaltsgerätes, angebracht.

Die als Touchscreen ausgestaltete Bedieneinrichtung kann in eine Bedienblende des Haushaltsgeräts integriert sein. Die Ausgestaltung der Bedienblende ist dabei erfindungsgemäß nicht eingeschränkt und kann je nach Ausführung des Haushaltsgerätes variieren. Bevorzugt ist die Bedienblende zumindest teilweise transparent, besonders bevorzugt ist die Bedienblende aus Plexiglas, beispielsweise schwarz, kann aber auch farbig sei. In einer weiteren bevorzugten Ausführungsform des Haushaltsgeräts ist die Bedienblende zudem geneigt angeordnet bezüglich des Gehäuses des Haushaltsgeräts, bevorzugt beträgt diese Neigung 10° bis 45°, besonders bevorzugt aber 25°. Auf diese Weise lässt sich insbesondere bei freistehenden Haushaltsgeräten der Touchscreen durch einen Benutzer leicht bedienen, da ein Benutzer bereits aus einer stehenden, nicht gebückten Haltung die Darstellung auf dem Touchscreen sehr gut erkennen kann. Außerdem kann zusätzlich eine Blendung des Benutzers durch reflektiertes Licht reduziert werden.

In einer besonders bevorzugten Ausführungsform der Erfindung ist die Bedieneinrichtung als externer Touchscreen ausgestaltet, d.h. insbesondere als externes mobiles Benutzerendgerät. Ganz besonders bevorzugt wird als Touchscreen ein zur Steuerung des Haushaltgerätes eingerichteter Tablet-Computer, Smartphone oder ein sonstiges mobiles Benutzerendgerät verwendet. Touchscreens finden nämlich im Allgemeinen auch Verwendung in Smartphones und Tablet-Computern. In einer weiteren bevorzugten Ausführungsform des erfindungsgemäßen Haushaltsgeräts ist die als Touchscreen ausgestaltete Bedieneinrichtung daher in ein mobiles externes Benutzerendgerät integriert, wozu in der Regel insbesondere auch eine bestimmte Bediensoftware im externen Benutzerendgerät vorhanden sein muss. Die Art des Benutzerendgeräts ist dabei erfindungsgemäß nicht eingeschränkt, solange es zur externen Kommunikation von Daten fähig ist.

Auf diese Weise wird es einem Benutzer ermöglicht, z. B. ein wasserführendes Haushaltsgerät extern zu bedienen und/oder dessen Betrieb zu überwachen, so dass er sich dazu nicht am Aufstellort des Haushaltsgeräts aufhalten muss. Besitzt das wasserführende Haushaltsgerät ein Dosiersystem für Behandlungsmittel, so kann in einer Ausführungsform von einem Benutzer über das mobile Benutzerendgerät z.B. auch der Vorratsstand an Behandlungsmittel im Dosiersystem abgefragt werden. Hierzu kann auf dem Touchscreen ein geeignetes Anzeigeelement auf einem oder mehreren Anzeigefeldern dargestellt sein.

In einer weiteren bevorzugten Ausführungsform des erfindungsgemäßen Haushaltsgeräts kann dieses zudem in ein Heimnetzwerk integriert sein und durch dieses bedient und/oder der Betrieb überwacht werden.

In diesen Fällen weist die Steuereinrichtung des Haushaltsgeräts eine Schnittstelle zur externen Kommunikation von Daten auf.

In einer weiteren bevorzugten Ausführungsform enthält das Haushaltsgerät einen Lichtsensor für die Helligkeit im Aufstellraum und die Steuereinrichtung ist eingerichtet, um eine Helligkeit des Touchscreens in Abhängigkeit von der gemessenen Helligkeit im Aufstellraum zu steuern. Lichtsensoren dienen im Allgemeinen zur Detektion einer Umgebungshelligkeit in Form eines Lichtwerts L_{U}. In einer weiteren bevorzugten Ausführungsform des erfindungsgemäßen wasserführenden Haushaltsgeräts ist daher zusätzlich ein Lichtsensor in das Haushaltsgerät integriert. Der Lichtsensor ist dabei erfindungsgemäß nicht eingeschränkt, solange er die Umgebungshelligkeit des Haushaltsgeräts detektieren kann. Der Lichtsensor ist dabei mit der Steuereinrichtung verbunden, welche vorzugsweise bei einer Abnahme der Umgebungshelligkeit die Helligkeit des Touchscreens erhöht, sowie bei einer Zunahme der Umgebungshelligkeit die Helligkeit des Touchscreens reduziert. Hierzu wird vorzugsweise ein Abgleich zwischen einem in der Steuereinrichtung hinterlegten Lichtwert Lₛₒₗₗ und dem Umgebungslichtwert L_{U} von der Steuereinrichtung durchgeführt. So kann einem Benutzer auch bei unterschiedlichen Umgebungshelligkeiten eine für das Auge angenehme Bedienung des Touchscreens bereitgestellt werden, beispielsweise an dunklen Aufstellorten und/oder bei Einbruch der Nacht.

Im Allgemeinen ist es bevorzugt, dass Touchscreens nicht jederzeit auf eine Berührung eines Benutzers reagieren. So ist es z.B. gewünscht, dass ein Smartphone, welches in einer Tasche transportiert wird, für diese Zeit berührungsunempfindlich ist. Ebenso gilt ähnliches beispielsweise für Tablet-Computer. Auf diese Weise kann aber z.B. auch eine Verwendung durch nicht autorisierte Benutzer verhindert werden.

In einer weiteren bevorzugten Ausführungsform des erfindungsgemäßen Haushaltsgeräts ist daher ein Haushaltsgerät bevorzugt, bei dem die Steuereinrichtung eingerichtet ist, nach einer Zeitspanne t_{Block}, in welcher kein anhand einer externen Eingabeeinheit erzeugtes Berührungssignal registriert wurde, eine Benutzung des Touchscreens zu blockieren und erst wieder nach einer Sicherheitseingabe durch einen Benutzer freizugeben. Die Sicherheitseingabe ist nicht beschränkt und umfasst Eingaben, z.B. Wischbewegungen oder die Eingabe von Sicherheitscodes, um einen Sperrbildschirm zu beseitigen. Auf diese Weise kann ein Haushaltsgerät z.B. kindersicher gemacht werden und/oder z.B. eine versehentlich erfolgte Eingabe verhindert werden. Vorzugsweise kann aber von einem Benutzer auch gewählt werden, ob eine Blockierung einer Touchscreen-Bedienung auf dem erfindungsgemäßen Haushaltsgerät aktiv sein soll oder nicht.

Unter einem Haushaltsgerät zur Behandlung von Gegenständen wird vorliegend in der Regel ein Gerät verstanden, das zur Behandlung von Haushaltsgegenständen ausgebildet ist, z.B. von Wäschestücken, Geschirr und Lebensmitteln. Es kann ein Haushaltsgroßgerät sein, wie beispielsweise eine Waschmaschine, ein Waschtrockner, eine Geschirrspülmaschine, ein Gargerät, eine Dunstabzugshaube, ein Kältegerät, eine Kühl-Gefrier-Kombination oder ein Klimagerät. Es kann aber auch ein Haushaltskleingerät sein, wie beispielsweise ein Kaffee-Vollautomat oder eine Küchenmaschine.

Besonders bevorzugt weist allerdings ein wasserführendes Haushaltsgerät zahlreiche Möglichkeiten zur Einstellung von Steuergrößen auf, so dass die Benutzung für einen Benutzer des Haushaltsgerätes kompliziert sein kann. Dann erweist sich der im erfindungsgemäßen Haushaltsgerät vorgesehene Touchscreen sowie dessen Bedienung zur Steuerung des Haushaltsgeräts als besonders vorteilhaft.

Vorzugsweise ist das Haushaltsgerät daher ein wasserführendes Haushaltsgerät, ausgewählt aus der Gruppe bestehend aus Waschmaschine, Waschtrockner, Trockner und Geschirrspülmaschine. Ganz besonders bevorzugt ist das Haushaltsgerät eine Waschmaschine oder ein Waschtrockner.

Ein wasserführendes Haushaltsgerät verfügt im Allgemeinen über mindestens einen Sensor zur Bestimmung einer für den Betrieb des Haushaltsgeräts wichtigen Eigenschaft. Ist das Haushaltsgerät beispielsweise eine Waschmaschine, so könnten geeignete Sensoren Art und Menge der Beladung mit Wäsche und deren Verschmutzungsgrad ermitteln. Bei einem Waschtrockner könnten die Sensoren beispielsweise neben Art und Menge der Beladung mit Wäsche auch die Feuchte der Wäsche ermitteln. Anhand solcher Daten könnte die Steuereinrichtung bestimmte Verfahrensweisen bewerten und diese Bewertung dann in die Bedienung des Haushaltsgeräts mittels des Touchscreens einfließen lassen. Beispielsweise könnte die Steuereinrichtung die Eingabe eines problematischen Parameterwertes oder von problematischen Kombinationen von Parameterwerten blockieren, um beispielsweise eine Schädigung von empfindlichen Wäschestücken zu vermeiden.

Gegenstand der Erfindung ist außerdem ein Verfahren gemäß Anspruch 14.

Die Erfindung hat zahlreiche Vorteile. Durch die erfindungsgemäße Ausgestaltung des Touchscreens kann die Bedienung eines Haushaltsgerätes zur Behandlung von Gegenständen und insbesondere eines solchen wasserführenden Haushaltsgeräts für einen Benutzer intuitiver und übersichtlicher gestaltet werden.

Das erfindungsgemäße Haushaltsgerät stellt dem Benutzer nicht nur eine verbesserte Möglichkeit zur Kommunikation mit dem Haushaltsgerät zur Durchführung eines Behandlungsprogramms zur Verfügung, sondern ermöglicht auch eine verbesserte Informationsausgabe, beispielsweise in Form von Text, Bild und/oder Animationen. Insbesondere durch eine selektive Darstellung von Information, welche zu einem bestimmten Bedienzeitpunkt für einen Benutzer von Bedeutung ist und gerade dann erfolgt, aber auch durch eine Unterstützung der visuellen Wahrnehmbarkeit von wichtigen und unwichtigen Informationen durch die gezielte Hervorhebung oder Zurücksetzung von Informationen durch die Art der Darstellung. Insbesondere ermöglicht auch eine Ausführung des Touchscreens als externer Touchscreen ein solches Haushaltsgerät einfach und mobil, beispielsweise von außer Haus, zu bedienen.

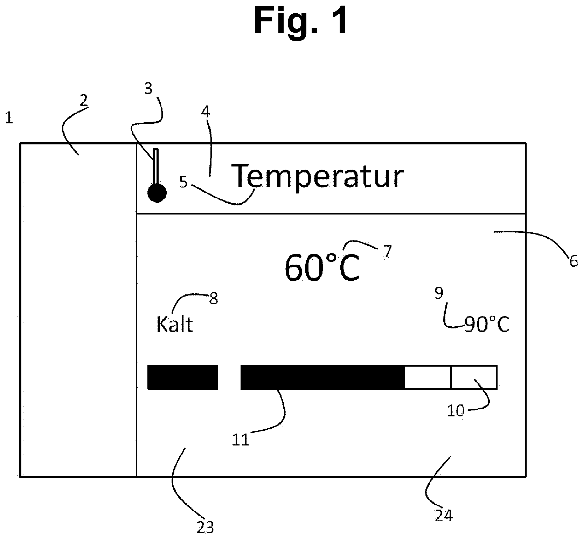

Weitere Einzelheiten der Erfindung ergeben sich aus der nachfolgenden Beschreibung nicht einschränkender Ausführungsformen. Hierbei wird Bezug genommen auf die Figuren 1 bis 3.

Figur 1 zeigt einen Touchscreen 1 einer nicht einschränkenden Ausführungsform eines erfindungsgemäßen Haushaltsgeräts, welches in dieser Ausführungsform als Waschmaschine ausgebildet ist. Beim Touchscreen 1 der Figur 1 ist der gesamte Flächenbereich des Touchscreens 1 berührungsempfindlich. Außerdem entspricht der Touchscreen 1 hier einer Bildschirmansicht, das heißt der gesamten Ansicht für einen Benutzer. Der Touchscreen 1 weist drei Anzeigefelder 2, 4 und 6 auf, welche den Touchscreen in 3 unterschiedlich große Teile unterteilen. Die Anzeigefeld 2 ist hier lediglich als Randbereich ausgeführt, es kann aber auch Informationen beispielsweise in Bezug auf ein übergeordnetes, durch einen Benutzer bereits ausgewähltes Behandlungsprogramm in Form von Anzeigeelementen darstellen. Das Anzeigefeld 4 weist ein Anzeigeelement Bild Thermometer 3 und ein Bedienelement Text "Temperatur" 5 auf. Mittels des Bedienelements 5 kann ein Benutzer das Anzeigefeld 6 öffnen zur Einstellung der Steuergröße Temperatur und nach erfolgter Einstellung auch wieder schließen. Es ist allerdings möglich, dass durch Berühren einer vorgeschalteten, hier nicht gezeigten Bildschirmanzeige, die hier als Touchscreen 1 bezeichnete nachgeschalte Bildschirmanzeige dargestellt und damit gleichzeitig das Anzeigefeld 6 geöffnet werden kann. Bei einer solchen Variante würden also die Anzeigefelder 4 und 6 gleichzeitig geöffnet. Schließlich wäre es auch möglich, dass nur das Anzeigefeld 6 für die Modifizierung einer Steuergröße geöffnet wird.

Ferner dienen das Anzeigeelement 3 und das Bedienelement 5 ebenfalls zur Information des Benutzers über die einzustellende Steuergröße, hier der Programmparameter Temperatur. Anzeigefeld 6 weist 3 Anzeigeelemente 7, 8, 9 und ein Bedienelement 10 auf. Das Bedienelement 10 ist ein längliches, flächiges Sensorelement aus hier sieben Segmenten 23,24, wobei jedem Segment ein bestimmter Temperaturwert zu seiner Einstellung zugeordnet ist und insbesondere das erste Segment 23 abgegrenzt dargestellt ist und der niedrigste einstellbare Wert der Temperaturskala diesem Segment zugeordnet ist. Das erste Segment 23 weist also einen erkennbaren Abstand zu den zweiten und weiteren Segmenten 24 auf. Der schwarze Bereich 11 zeigt bei dieser Ausführungsform einem Benutzer die durch Berührung erzeugte Einstellung, hier 60 °C. Das Anzeigeelement 7 Text "60°C" gibt die Information über die eingestellte Temperatur an einen Benutzer aus. Das Anzeigeelement 7 ist dabei vergrößert dargestellt, um eine bessere Übersichtlichkeit zu ermöglichen. Die Anzeigeelemente 8 und 9 Text "Kalt" und Text "90°C" geben die Information über den niedrigsten Wert, hier Kalt, und den höchsten Wert der Temperaturwerteskala an einen Benutzer aus. Vorzugsweise werden die Anzeigeelemente 8 und 9 dabei gleichzeitig mit oder unmittelbar nach einer ersten Berührung des Sensorelements 10 dargestellt. Auf diese Weise kann die Komplexität der Darstellung zunächst übersichtlicher gehalten werden, da für einen bestimmten Bedienzeitpunkt relevante Informationen, hier der Bereich der Temperaturwerteskala, erst dargestellt werden, wenn sie für einen Benutzer wichtig sind.

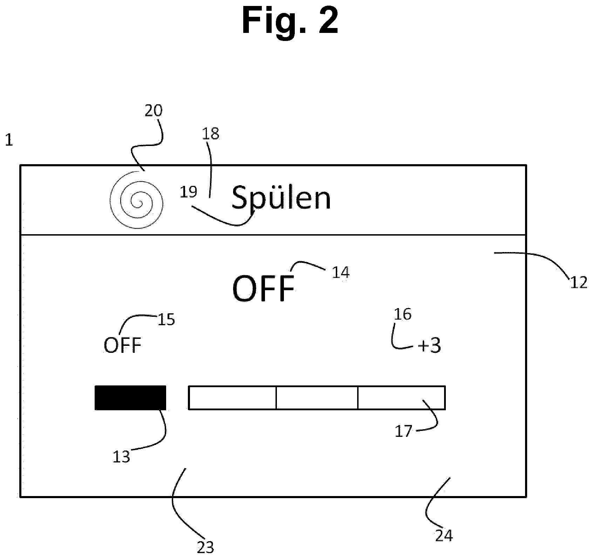

Figur 2 zeigt einen Touchscreen 1 wie er in einer zweiten Ausführungsform eines erfindungsgemäßen Haushaltsgerätes eingesetzt wird. Der Touchscreen 1, der auch hier einer Bildschirmansicht entspricht, weist in dieser Ausführungsform zwei Anzeigefelder 12 und 18 auf, welche den Touchscreen in zwei unterschiedlich große Teile unterteilen. Das Anzeigefeld 18 weist dabei das Anzeigeelement Bild Spirale 20 und das Bedienelement Text "Spülen" 19 auf. welche die gleichen Funktionen erfüllen, wie unter Figur 1 bereits beschrieben. Mittels des Bedienelements 19 kann ein Benutzer das Anzeigefeld 12 öffnen zur Einstellung der Zusatzoption Spülen und nach erfolgter Einstellung auch wieder schließen. Ferner dienen das Anzeigeelement 20 und das Bedienelement 19 ebenfalls zur Information des Benutzers über die einzustellende Steuergröße, hier der Programmparameter Spülen. Das Anzeigefeld 12 weist drei Anzeigeelemente 14, 15 und 16 auf, sowie ein Bedienelement 17. Das Bedienelement 17 ist als längliches, flächiges Sensorelement mit vier Segmenten ausgebildet. Ein Benutzer kann also durch eine Berührung einen zusätzlichen Spülvorgang mittels des Bedienelements 17 auswählen oder diese Zusatzoption ausschalten. Hierzu ist insbesondere das erste Segment 23 abgegrenzt, d.h. mit einem Abstand von den weiteren Segmenten 24, dargestellt und diesem die Funktion OFF als Anzeige der Deaktivierung der Steuergröße Spülen, welche in dieser Ausführungsform OFF und drei zusätzliche Spülvorgänge umfasst, zugeordnet. Der schwarze Bereich 13 kennzeichnet dabei die von einem Benutzer getroffene Einstellung OFF, welche ebenfalls durch das Anzeigeelement Text "OFF" 14 dargestellt ist. Die Anzeigeelemente 15 und 16, Text "OFF" und Text "+3" zeigen insbesondere den Deaktivierungszustand und den höchsten Wert der Werteskala Spülen an. Diese Anzeigeelemente werden aber bevorzugt gleichzeitig mit oder unmittelbar nach einer ersten Berührung des Bedienelements 17 dargestellt.

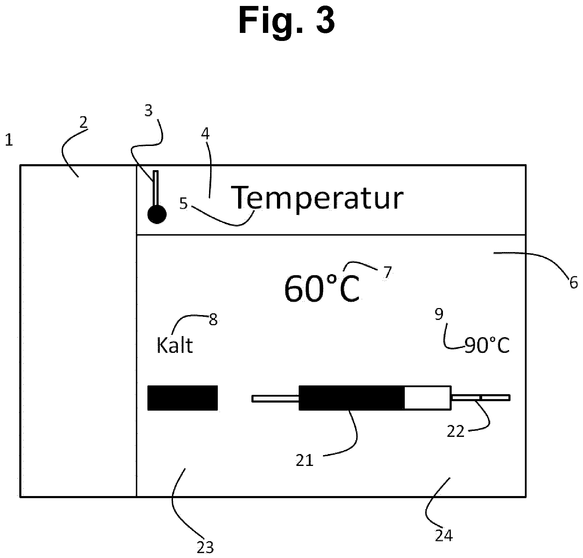

Figur 3 zeigt einen Touchscreen 1 wie er in einer dritten Ausführungsform eines erfindungsgemäßen Haushaltsgerätes eingesetzt wird. Der Touchscreen 1 weist in dieser Ausführungsform wiederum die drei Anzeigefelder 2, 4 und 6 auf. Wie bereits unter Figur 1 beschrieben, weist das Anzeigefeld 4 ein Anzeigeelement Bild Thermometer 3 und ein Bedienelement Text "Temperatur" 5 auf. Mittels des Bedienelements 5 kann ein Benutzer das Anzeigefeld 6 öffnen zur Einstellung der Steuergröße Temperatur und nach erfolgter Einstellung auch wieder schließen. Ferner dienen das Anzeigeelement 3 und das Bedienelement 5 ebenfalls zur Information des Benutzers über die einzustellende Steuergröße, hier der Programmparameter Temperatur. Anzeigefeld 6 umfasst wiederum die drei Anzeigeelemente 6, 7, 8 und das Bedienelement 22. Das Bedienelement 22 ist ebenfalls ein längliches, flächiges Sensorelement aus sieben Segmenten. Von diesen sieben Segmenten können jedoch nur vier durch einen Benutzer eingestellt werden, die Einstellung der anderen drei ist durch die Steuereinrichtung blockiert. Somit besitzen die drei blockierten Segmente eine geringere Geltung G2 für einen Benutzer als die einstellbaren vier Segmente, welche die Geltung G1 besitzen. Entsprechend sind in dieser Ausführungsform die Segmente mit geringerer Geltung formverändert dargestellt, hier in ihrer Höhe verringert, so dass für einen Benutzer die Blockierung der Einstellung visuell leicht zu erfassen ist. Der schwarze Bereich 21 kennzeichnet auch hier die durch den Benutzer getroffene Einstellung, welche durch das Anzeigeelement Text "60°C" 7 ebenfalls angezeigt ist. Die beiden Anzeigeelemente Text "Kalt" 8 und Text "90°C" 9 geben entsprechend wiederum den niedrigsten und den höchsten Wert der Werteskala Temperatur wieder, wobei der niedrigste Wert dem ersten Segment 23 des Bedienelements 22 zugeordnet ist, welches von den restlichen Segmenten 24 beabstandet dargestellt ist.

### Bezugszeichen

- 1: Touchscreen
- 2: Anzeigefeld
- 3: Anzeigeelement Bild Thermometer
- 4: Anzeigefeld
- 5: Bedienelement Text "Temperatur"
- 6: Anzeigefeld
- 7: Anzeigeelement Text "60°C"
- 8: Anzeigeelement Text "Kalt"
- 9: Anzeigeelement Text "90°C"
- 10: Längliches, flächiges Sensorelement
- 11: erzeugter, eingestellter Bereich
- 12: Anzeigefeld
- 13: erzeugter, eingestellter Bereich
- 14: Anzeigeelement Text "OFF"
- 15: Anzeigeelement Text "OFF"
- 16: Anzeigeelement Text "+3"
- 17: Längliches, flächiges Sensorelement
- 18: Anzeigefeld
- 19: Bedienelement Text "Spülen"
- 20: Anzeigeelement Bild Spirale
- 21: erzeugter, eingestellter Bereich
- 22: Längliches, flächiges Sensorelement mit teilweise blockierter Eingabe
- 23: Erstes Segment
- 24: Weitere Segmente; zweites und weitere Segmente

## Patentansprüche

1. Haushaltsgerät zur Behandlung von Gegenständen, aufweisend eine Steuereinrichtung und eine als externer oder interner Touchscreen (1) ausgestaltete Bedieneinrichtung, wobei die Steuereinrichtung eingerichtet ist, um auf mindestens einem Teil des Touchscreens (1) innerhalb einer Bildschirmanzeige ein Anzeigefeld (2,4,6,12,18) darzustellen, in dem mindestens ein Bedienelement (5,10,17,19,22) und mindestens ein Anzeigeelement (3,7,8,9,14,15,16) zur Einstellung und Anzeige einer durch Berührung einstellbaren Steuergröße des Haushaltsgerätes angeordnet sind, wobei
(a) das mindestens eine Bedienelement (10,17,22) ein längliches, flächiges Sensorelement (10,17,22) mit einem ersten Segment (23) und mindestens zwei weiteren Segmenten (24) beinhaltet, wobei dem ersten Segment (23) ein niedrigster Wert der einstellbaren Steuergröße zugeordnet ist und den mindestens zwei weiteren Segmenten (24) jeweils unterschiedliche Werte der einstellbaren Steuergröße zugeordnet sind; und
(b) die Steuereinrichtung eingerichtet ist, nach und/oder gleichzeitig mit einer Berührung des Sensorelements (10,17,22) mindestens zwei Anzeigeelemente (8,9,15,16) darzustellen, wobei das erste Anzeigeelement (8,15) den niedrigsten einstellbaren Wert der Steuergröße anzeigt und das zweite Anzeigeelement (9,16) den höchsten einstellbaren Wert der Steuergröße anzeigt,
**dadurch gekennzeichnet, dass** zwischen dem ersten Segment (23) und den weiteren Segmenten (24) ein größerer Abstand besteht als zwischen den weiteren Segmenten (24), so dass das erste Segment (23) von den weiteren Segmenten (24) abgegrenzt dargestellt ist.

2. Haushaltsgerät nach Anspruch 1, **dadurch gekennzeichnet, dass** das Sensorelement (10,17,22) ein kapazitives Sensorelement ist.

3. Haushaltsgerät nach einem der vorigen Ansprüche, **dadurch gekennzeichnet, dass** die Bedieneinrichtung als externer Touchscreen (1) ausgestaltet ist, insbesondere ein zur Steuerung des Haushaltgerätes eingerichteter Tablet-Computer oder Smartphone ist.

4. Haushaltsgerät nach einem der vorigen Ansprüche, **dadurch gekennzeichnet, dass** es einen Soundgenerator und einen Lautsprecher zur Erzeugung und Wiedergabe von im Zusammenhang mit der Einstellung der Steuergrößen stehenden akustischen Signalen aufweist.

5. Haushaltsgerät nach einem der vorigen Ansprüche, **dadurch gekennzeichnet, dass** das Haushaltsgerät einen Lichtsensor für die Helligkeit im Aufstellraum enthält und die Steuereinrichtung eingerichtet ist, um eine Helligkeit des Touchscreens (1) in Abhängigkeit von der gemessenen Helligkeit im Aufstellraum zu steuern.

6. Haushaltsgerät nach einem der vorigen Ansprüche, **dadurch gekennzeichnet, dass** die Steuereinrichtung eingerichtet ist, nach einer Zeitspanne t_{Block}, in welcher kein anhand einer externen Eingabeeinheit erzeugtes Berührungssignal registriert wurde, eine Benutzung des Touchscreens (1) zu blockieren und erst wieder nach einer Sicherheitseingabe durch einen Benutzer freizugeben.

7. Haushaltsgerät nach einem der vorigen Ansprüche, **dadurch gekennzeichnet, dass** das Haushaltsgerät ein wasserführendes Haushaltsgerät, ausgewählt aus der Gruppe bestehend aus Waschmaschine, Waschtrockner, Trockner und Geschirrspülmaschine ist.

8. Haushaltsgerät nach Anspruch 7, **dadurch gekennzeichnet, dass** es eine Waschmaschine oder ein Waschtrockner ist.

9. Haushaltsgerät nach einem der vorigen Ansprüche, **dadurch gekennzeichnet, dass** die Steuereinrichtung eingerichtet ist, Bedienelemente (5, 10, 17, 19, 22) und/oder Anzeigeelemente (3, 7-9, 14-16, 20) mit einer höheren Geltung G1 farblich hervorgehoben und/oder kontrastreich darzustellen und Bedienelemente (5, 10, 17, 19, 22) und/oder Anzeigeelemente (3, 7-9, 14-16, 20) mit einer niedrigeren Geltung G2<G1 farblich zurückgesetzt, kontrastärmer und/oder in unterschiedlicher Form darzustellen.

10. Haushaltsgerät nach einem der vorigen Ansprüche, **dadurch gekennzeichnet, dass** einstellbare Steuergrößen des Haushaltsgeräts Behandlungsprogramme, Programmparameter und/oder Zusatzoptionen umfassen.

11. Haushaltsgerät nach einem der vorigen Ansprüche, **dadurch gekennzeichnet, dass** in der Steuereinrichtung Abhängigkeiten für einstellbare Steuergrößen hinterlegt sind, und die Steuereinrichtung eingerichtet ist, eine unvorteilhafte und/oder Schaden verursachende Einstellung von Steuergrößen basierend auf diesen Abhängigkeiten zu blockieren.

12. Haushaltsgerät nach einem der vorigen Ansprüche, **dadurch gekennzeichnet, dass** die Steuereinrichtung eingerichtet ist, zusätzlich den unmittelbaren Start eines Behandlungsprogrammes zu ermöglichen, indem ein hierfür vorgesehener Teilbereich eines Bedienelementes (5, 10, 17, 19, 22) berührt wird.

13. Haushaltsgerät nach einem der vorigen Ansprüche, **dadurch gekennzeichnet, dass** die Steuereinrichtung eingerichtet ist, zusätzlich den Wechsel zwischen einer Bildschirmanzeige B1 und einer Bildschirmanzeige B2 zu ermöglichen, indem ein hierfür vorgesehener Teilbereich eines Bedienelementes (5,10,17,19,22) berührt wird.

14. Verfahren zum Betrieb eines Haushaltsgerätes zur Behandlung von Gegenständen, aufweisend eine Steuereinrichtung und eine als externer oder interner Touchscreen (1) ausgestaltete Bedieneinrichtung, wobei die Steuereinrichtung eingerichtet ist, um auf mindestens einem Teil des Touchscreens (1) innerhalb einer Bildschirmanzeige ein Anzeigefeld (6, 12) darzustellen, wobei auf dem Anzeigefeld mindestens ein Bedienelement (10, 17, 22) und mindestens zwei Anzeigeelemente (8, 9, 15, 16) dargestellt sind, und wobei durch das mindestens eine Bedienelement (5, 10, 17, 19, 22) eine einstellbare Steuergröße des Haushaltsgeräts durch Berührung einstellbar ist, das Bedienelement (10, 17, 22) ein längliches, flächiges Sensorelement (10, 17, 22) aus mindestens 3 Segmenten ist, und wobei die einstellbare Steuergröße eine Werteskala mit mindestens drei Werten umfasst, wobei jedem Segment ein Wert der Werteskala zugeordnet ist, derart, dass eine Einstellung eines Wertes durch Berührung mittels einer externen Eingabeeinheit erfolgt, wobei sich die einstellbare Steuergröße kontinuierlich oder sprunghaft ändert, und wobei dem ersten Segment ein niedrigster einstellbarer Wert zugeordnet ist, und wobei die Steuereinrichtung eingerichtet ist, nach und/oder gleichzeitig mit einer ersten Berührung des Sensorelements (10,17, 22) die mindestens zwei Anzeigeelemente (8,9,15,16) darzustellen, wobei das erste Anzeigeelement (8,15) den niedrigsten einstellbaren Wert der Werteskala anzeigt, und wobei das zweite Anzeigeelement (9,16) den höchsten einstellbaren Wert der Werteskala anzeigt,
wobei zwischen dem ersten Segment (23) und den weiteren Segmenten (24) ein größerer Abstand besteht als zwischen den weiteren Segmenten (24), so dass das erste Segment (23) von den weiteren Segmenten (24) abgegrenzt dargestellt ist, umfassend die Schritte:
(i) Darstellung eines Anzeigefeldes (2,4,6,12,18) innerhalb einer Bildschirmanzeige; wobei in dem Anzeigefeld (2,4,6,12,18) als mindestens ein Bedienelement ein längliches, flächiges Sensorelement (10,17,22) mit einem ersten Segment (23) und mindestens zwei weiteren Segmenten (24) angeordnet ist, wobei dem ersten Segment (23) ein niedrigster Wert der einstellbaren Steuergröße zugeordnet ist und den mindestens zwei weiteren Segmenten (24) jeweils unterschiedliche Werte der einstellbaren Steuergröße zugeordnet sind;
(ii) nach und/oder gleichzeitig mit einer Berührung des Sensorelements (10,17,22) Darstellung von mindestens zwei Anzeigeelementen (8,9,15,16) zur Anzeige einer durch Berührung einstellbaren Steuergröße des Haushaltsgerätes, wobei das erste Anzeigeelement (8,15) den niedrigsten einstellbaren Wert der Steuergröße und das zweite Anzeigeelement (9,16) den höchsten einstellbaren Wert der Steuergröße anzeigt;
(iii) Modifizieren der einstellbaren Steuergröße entsprechend einer Berührung des Sensorelementes (10,17,22); und
(iv) Durchführung eines Behandlungsprogrammes mit der modifizierten Steuergröße.

## Claims

1. Household appliance for treating objects, having a control device and an operating device designed as an external or internal touch screen (1), wherein the control device is configured to display a display field (2, 4, 6, 12, 18) on at least a part of the touch screen (1) within a screen display, in which display field are arranged at least one operating element (5, 10, 17, 19, 22) and at least one display element (3, 7, 8, 9, 14, 15, 16) for setting and displaying a control variable of the household appliance which is settable by touch, wherein
(a) the at least one operating element (10, 17, 22) contains an elongate, flat sensor element (10, 17, 22) with a first segment (23) and at least two further segments (24), wherein associated with the first segment (23) is a lowest value of the settable control variable and associated with each of the at least two further segments (24) are different values of the settable control variable; and
(b) the control device is configured to display at least two display elements (8, 9, 15, 16) after and/or simultaneously with a touching of the sensor element (10, 17, 22), wherein the first display element (8, 15) displays the lowest settable value of the control variable and the second display element (9, 16) displays the highest settable value of the control variable
**characterised in that** between the first segment (23) and the further segments (24), a larger spacing exists than between the further segments (24), so that the first segment (23) is represented delimited from the further segments (24).

2. Household appliance according to claim 1, **characterised in that** the sensor element (10, 17, 22) is a capacitive sensor element.

3. Household appliance according to one of the preceding claims, **characterised in that** the operating device is designed as an external touch screen (1), in particular a tablet computer or smartphone configured for controlling the household appliance.

4. Household appliance according to one of the preceding claims, **characterised in that** it has a sound generator and a loudspeaker for generating and reproducing acoustic signals in relation to the setting of the control variables.

5. Household appliance according to one of the preceding claims, **characterised in that** the household appliance contains a light sensor for the brightness in the siting area and the control device is configured to control a brightness of the touch screen (1) depending upon the measured brightness in the siting area.

6. Household appliance according to one of the preceding claims, **characterised in that** the control device is configured, following a time span t_{Block} during which no touch signal generated by means of an external input unit has been registered, to block a use of the touch screen (1) and to free it again only after a security input by a user.

7. Household appliance according to one of the preceding claims, **characterised in that** the household appliance is a water-using household appliance selected from the group consisting of washing machine, washer-dryer, dryer and dishwasher.

8. Household appliance according to claim 7, **characterised in that** it is a washing machine or a washer-dryer.

9. Household appliance according to one of the preceding claims, **characterised in that** the control device is configured to display operating elements (5, 10, 17, 19, 22) and/or display elements (3, 7-9, 14-16, 20) with a higher validity G1 emphasised with colour and/or in high contrast and to display operating elements (5, 10, 17, 19, 22) and/or display elements (3, 7-9, 14-16, 20) with a lower validity G2<G1 suppressed in colour, in lower contrast and/or in a different form.

10. Household appliance according to one of the preceding claims, **characterised in that** settable control variables of the household appliance comprise treatment programs, program parameters and/or additional options.

11. Household appliance according to one of the preceding claims, **characterised in that** in the control device dependencies for settable control variables are stored and the control device is configured to block a disadvantageous and/or damage-causing setting of control variables based upon these dependencies.

12. Household appliance according to one of the preceding claims, **characterised in that** the control device is configured also to enable the direct start of a treatment program by a subregion of an operating element (5, 10, 17, 19, 22) provided herefor being touched.

13. Household appliance according to one of the preceding claims, **characterised in that** the control device is configured also to enable the change between a screen display B 1 and a screen display B2 by a subregion of an operating element (5, 10, 17, 19, 22) provided herefor being touched.

14. Method for operating a household appliance for treating objects, having a control device and an operating device designed as an external or internal touch screen (1), wherein the control device is configured to display a display field (6, 12) on at least a part of the touch screen (1) within a screen display, wherein on the display field at least one operating element (10, 17, 22) and at least two display elements (8, 9, 15, 16) are displayed, and wherein by means of the at least one operating element (5, 10, 17, 19, 22), a settable control variable of the household appliance is settable by touch, wherein the operating element (10, 17, 22) is an elongate flat sensor element (10, 17, 22) consisting of at least three segments and wherein the settable control variable comprises a value scale with at least three values, wherein a value of the value scale is associated with each segment, such that a setting of a value takes place by touching by means of an external input unit, wherein the settable control variable changes continuously or in jumps, and wherein a lower settable value is associated with the first segment, and wherein the control device is configured to display the at least two display elements (8, 9, 15, 16) following and/or simultaneously with a first touch of the sensor element (10, 17, 22), wherein the first display element (8, 15) displays the lowest settable value of the value scale, and wherein the second display element (9, 16) displays the highest settable value of the value scale,
wherein between the first segment (23) and the further segments (24), a larger spacing exists than between the further segments (24), so that the first segment (23) is represented delimited from the further segments (24), comprising the steps:
(i) display of a display field (2, 4, 6, 12, 18) within a screen display; wherein in the display field (2, 4, 6, 12, 18) as at least one operating element, an elongate, flat sensor element (10, 17, 22) with a first segment (23) and at least two further segments (24) is arranged, wherein a lowest value of the settable control variable is associated with the first segment (23) and different values of the settable control variable are associated respectively with the at least two further segments (24);
(ii) following and/or simultaneously with a touching of the sensor element (10, 17, 22), display of at least two display elements (8, 9, 15, 16) for the display of a control variable of the household appliance which is settable by touch, wherein the first display element (8, 15) displays the lowest settable value of the control variable and the second display element (9, 16) displays the highest settable value of the control variable;
(iii) modification of the settable control variable according to a touching of the sensor element (10, 17, 22); and
(iv) carrying out a treatment program with the modified control variable.

## Revendications

1. Appareil ménager destiné au traitement d'objets, présentant un dispositif de commande et un dispositif de manipulation conçu comme écran tactile (1) externe ou interne, dans lequel le dispositif de commande est configuré pour représenter sur au moins une partie de l'écran tactile (1) un champ d'affichage (2, 4, 6, 12, 18) à l'intérieur d'un affichage d'écran, dans lequel au moins un élément de commande (5, 10, 17, 19, 22) et au moins un élément d'affichage (3, 7, 8, 9, 14, 15, 16) destinés au réglage et à l'affichage d'une grandeur de commande réglable, par contact, de l'appareil ménager sont disposés, dans lequel
(a) l'au moins un élément de commande (10, 17, 22) comprend un élément capteur (10, 17, 22) plat allongé comprenant un premier segment (23) et au moins deux segments supplémentaires (24), dans lequel une valeur plus basse de la grandeur de commande réglable est attribuée au premier segment (23) et des valeurs respectivement différentes de la grandeur de commande réglable sont attribuées aux au moins deux segments supplémentaires (24) ; et
(b) le dispositif de commande est configuré pour représenter au moins deux éléments d'affichage (8, 9, 15, 16) après et/ou simultanément à un contact de l'élément capteur (19, 17, 22), le premier élément d'affichage (8, 15) affichant la valeur réglable la plus basse de la grandeur de commande et le deuxième élément d'affichage (9, 16) affichant la valeur réglable la plus élevée de la grandeur de commande,
**caractérisé en ce qu'**entre le premier segment (23) et les segments supplémentaires (24) il existe un écart plus grand qu'entre les segments supplémentaires (24), de sorte que le premier segment (23) est représenté de manière délimitée des segments supplémentaires (24).

2. Appareil ménager selon la revendication 1, **caractérisé en ce que** l'élément capteur (10, 17, 22) est un élément capteur capacitif.

3. Appareil ménager selon l'une quelconque des revendications précédentes, **caractérisé en ce que** le dispositif de manipulation est conçu comme écran tactile (1) externe, notamment **en ce qu'**il est un ordinateur-tablette ou un smartphone configuré pour la commande de l'appareil ménager.

4. Appareil ménager selon l'une quelconque des revendications précédentes, **caractérisé en ce qu'**il présente un générateur de son et un haut-parleur destinés à générer et reproduire des signaux acoustiques en relation avec le réglage des grandeurs de commande.

5. Appareil ménager selon l'une quelconque des revendications précédentes, **caractérisé en ce que** l'appareil ménager comprend un capteur de lumière pour la luminosité dans le lieu d'installation et **en ce que** le dispositif de commande est configuré pour commander une luminosité de l'écran tactile (1) en fonction de la luminosité mesurée dans le lieu d'installation.

6. Appareil ménager selon l'une quelconque des revendications précédentes, **caractérisé en ce que** le dispositif de commande est configuré pour bloquer une utilisation de l'écran tactile (1) après un laps de temps t_{Block}, pendant lequel aucun signal de contact généré à l'aide d'une unité d'entrée externe n'a été enregistré, et pour la libérer de nouveau seulement après une entrée de sécurité par un utilisateur.

7. Appareil ménager selon l'une quelconque des revendications précédentes, **caractérisé en ce que** l'appareil ménager est un appareil ménager à circulation d'eau, sélectionné dans le groupe constitué de lave-linge, lave-linge séchant, sèche-linge et lave-vaisselle.

8. Appareil ménager selon la revendication 7, **caractérisé en ce qu'**il est un lave-linge ou un lave-linge séchant.

9. Appareil ménager selon l'une quelconque des revendications précédentes, **caractérisé en ce que** le dispositif de commande est configuré pour souligner en couleur les éléments de commande (5, 10, 17, 19, 22) et/ou les éléments d'affichage (3, 7 - 9, 14 - 16, 20) ayant une validité G1 plus élevée, et/ou pour les représenter de manière plus contrastée, et pour remettre à l'état initial en couleur les éléments de commande (5, 10, 17, 19, 22) et/ou les éléments d'affichage (3, 7 - 9, 14 - 16, 20) ayant une validité plus basse G2<G1, pour les représenter avec moins de contraste et/ou sous forme différente.

10. Appareil ménager selon l'une quelconque des revendications précédentes, **caractérisé en ce que** les grandeurs de commande réglables de l'appareil ménager comprennent des programmes de traitement, des paramètres de programme et/ou des options supplémentaires.

11. Appareil ménager selon l'une quelconque des revendications précédentes, **caractérisé en ce que** des dépendances pour des grandeurs de commande réglables sont mémorisées dans le dispositif de commande, et **en ce que** le dispositif de commande est configuré pour bloquer un réglage défavorable, et/ou provoquant un dommage, de grandeurs de commande sur la base de ces dépendances.

12. Appareil ménager selon l'une quelconque des revendications précédentes, **caractérisé en ce que** le dispositif de commande est configuré, en outre, pour permettre le démarrage immédiat d'un programme de traitement du fait qu'une zone partielle d'un élément de commande (5, 10, 17, 19, 22), ménagée à cet effet, est touchée.

13. Appareil ménager selon l'une quelconque des revendications précédentes, **caractérisé en ce que** le dispositif de commande est configuré, en outre, pour permettre la commutation entre un affichage d'écran B1 et un affichage d'écran B2 du fait qu'une zone partielle d'un élément de commande (5, 10, 17, 19, 22), ménagée à cet effet, est touchée.

14. Procédé de fonctionnement d'un appareil ménager destiné au traitement d'objets, présentant un dispositif de commande et un dispositif de manipulation conçu comme écran tactile (1) externe ou interne, dans lequel le dispositif de commande est configuré pour représenter sur au moins une partie de l'écran tactile (1) un champ d'affichage (6, 12) à l'intérieur d'un affichage d'écran, dans lequel au moins un élément de commande (10, 17, 22) et au moins deux éléments d'affichage (8, 9, 15, 16) sont représentés sur le champ d'affichage, et dans lequel une grandeur de commande réglable de l'appareil ménager est réglable par contact au moyen de l'au moins un élément de commande (5, 10, 17, 19, 22), dans lequel l'élément de commande (10, 17, 22) est un élément capteur (10, 17, 22) plat allongé constitué d'au moins 3 segments, et dans lequel la grandeur de commande réglable comprend une échelle de valeurs comprenant au moins trois valeurs, une valeur de l'échelle de valeurs étant attribuée à chaque segment de manière à ce qu'un réglage d'une valeur soit effectué par contact au moyen d'une unité d'entrée externe, la grandeur de commande réglable se modifiant de manière continue ou par sauts, et une valeur réglable plus basse étant attribuée au premier segment, et dans lequel le dispositif de commande est configuré pour représenter les au moins deux éléments d'affichage (8, 9, 15, 16) après et/ou simultanément à un premier contact de l'élément capteur (10, 17, 22), dans lequel le premier élément d'affichage (8, 15) affiche la valeur réglable la plus basse de l'échelle de valeurs, et dans lequel le deuxième élément d'affichage (9, 16) affiche la valeur la plus élevée de l'échelle de valeurs, dans lequel entre le premier segment (23) et les segments supplémentaires (24), il existe un écart plus grand qu'entre les segments supplémentaires (24) de sorte que le premier segment (23) est représenté de manière délimitée des segments supplémentaires (24), comprenant les étapes :
(i) représentation d'un champ d'affichage (2, 4, 6, 12, 18) à l'intérieur d'un affichage d'écran, dans lequel un élément capteur (10, 17, 22) plat allongé comprenant un premier segment (23) et au moins deux segments supplémentaires (24) est disposé dans le champ d'affichage (2, 4, 6, 12, 18) en tant qu'au moins un élément de commande, dans lequel une valeur plus basse de la grandeur de commande réglable est attribuée au premier segment (23) et des valeurs respectivement différentes de la grandeur de commande réglable sont attribuées aux au moins deux segments supplémentaires (24) ;
(ii) représentation d'au moins deux éléments d'affichage (8, 9, 15, 16), après et/ou simultanément à un contact de l'élément capteur (10, 17, 22), pour l'affichage d'une grandeur de commande réglable, par contact, de l'appareil ménager, le premier élément d'affichage (8, 15) affichant la valeur réglable la plus basse de la grandeur de commande et le deuxième élément d'affichage (9, 16) affichant la valeur réglable la plus élevée de la grandeur de commande ;
(iii) modification de la grandeur de commande réglable conformément à un contact de l'élément capteur (10, 17, 22) ; et
(iv) exécution d'un programme de traitement avec la grandeur de commande modifiée.
